# FASCICULE DE BREVET EUROPEEN

(11) **EP 2 976 929 B1**
(45) Date de publication et mention de la délivrance du brevet: **12.12.2018**
(21) Numéro de dépôt: 14712260.0
(22) Date de dépôt: 19.03.2014
(51) Int. Cl.: H05K 1/03, H05K 1/18, H05K 3/02, H05K 3/30, G06K 19/077, H05K 3/32

(54) **PROCÉDÉ DE FABRICATION D'UN CIRCUIT IMPRIMÉ FLEXIBLE, CIRCUIT IMPRIMÉ FLEXIBLE OBTENU PAR CE PROCÉDÉ ET MODULE DE CARTE À PUCE COMPORTANT UN TEL CIRCUIT IMPRIMÉ FLEXIBLE**
VERFAHREN ZUR HERSTELLUNG EINER LEITERPLATTE, MITTELS DIESES VEFAHREN HERGESTELLTE LEITERPLATTE UND CHIPMODUL UMFASSEND EINER SOLCHEN LEITERPLATTE
PROCESS FOR MANUFACTURING A PRINTED CIRCUIT, PRINTED CIRCUIT OBTAINED BY SUCH A PROCESS AND CHIP MODULE COMPRISING SUCH A PRINTED CIRCUIT

(30) Priorité: 19.03.2013 FR 1352468; 02.08.2013 FR 1357749
(43) Date de publication de la demande: 27.01.2016
(73) Titulaire: Linxens Holding, 78280 Guyancourt (FR)
(72) Inventeur: MATHIEU, Christophe, F-78200 Mantes La Jolie (FR); BOUZID, Nordin, F-78200 Magnanville (FR)
(74) Mandataire: Regi, François-Xavier
(86) Numéro de dépôt international: PCT/EP2014/055555
(87) Numéro de publication internationale: WO 2014/147154

(56) Documents cités:
- EP-A1- 1 975 856
- US-A- 4 833 022
- US-A- 4 869 956
- US-A1- 2001 030 122
- US-A1- 2010 129 604

## Description

L'invention concerne le domaine des circuits imprimés flexibles. De tels circuits imprimés flexibles peuvent être utilisés par exemple pour réaliser des modules électroniques pour carte à puce, des antennes RFID, des diodes électroluminescentes.

L'invention est illustrée ci-dessous en prenant l'exemple des modules électroniques pour cartes à puce, mais elle est facilement transposable à d'autres applications des circuits imprimés flexibles tels que ceux mentionnés ci-dessus.

Les cartes à puce sont bien connues du public, qui en a de multiples usages : cartes de crédit, carte SIM pour téléphones portable, cartes de transport, cartes d'identité, etc.

Les cartes à puce sont généralement constituées d'un support rigide en matière plastique de type PVC, PVC/ABS ou polycarbonate constituant l'essentiel de la carte, dans lequel est incorporé un module électronique fabriqué séparément. Ce module électronique comporte un circuit imprimé généralement flexible muni d'une puce électronique (circuit intégré) et de moyens de transmission pour transmettre des données de la puce à un dispositif lecteur de carte (lecture) ou de ce dispositif à la carte (écriture). Le document EP1975856A1 par exemple décrit un tel circuit imprimé. Les moyens de transmission de données peuvent être « à contact », « sans contact » ou bien « dual » lorsqu'ils combinent les deux précédents moyens.

Dans une carte à puce « à contact », un connecteur comporte des plages de contacts électriquement connectés à la puce et affleurant sur le module électronique, en surface du support, pour une connexion par contact électrique avec un dispositif lecteur de carte. Dans une carte à puce « sans contact », les données sont transmises à la puce grâce à un système radiofréquence fonctionnant entre une antenne se trouvant dans le lecteur et une antenne se trouvant dans la carte. Dans une carte à puce « dual », les moyens de transmission sont à la fois « à contact » et « sans contact », le module électronique comportant un circuit flexible est muni d'une unique puce électronique capable de gérer les deux modes de transmissions de données.

Dans la suite de ce document, nous nous intéressons plus particulièrement aux circuits flexibles des modules de cartes à puce « à contact » et « dual », mais l'invention concerne tous les types de cartes à puce.

Dans l'art antérieur, les modules sont généralement formés à partir d'un substrat diélectrique recouvert sur au moins l'une de ses faces d'une couche électriquement conductrice, constituée par exemple d'un métal tel que du cuivre ou un alliage de cuivre, de l'acier ou de l'aluminium. Dans cette couche conductrice sont formés des moyens de transmission tels que des plages de contacts électriques. Les substrats diélectriques utilisés dans l'art antérieur sont réalisés en matériaux composites (verre-époxy) ou en matériaux plastiques (PET, PEN, polyimide, etc.). Ce substrat diélectrique est généralement mince (dont l'épaisseur est par exemple de l'ordre de 100 µm) pour conserver une flexibilité compatible avec des procédés de fabrication des modules électroniques en continu. L'ensemble constitué du substrat recouvert de la couche conductrice forme un circuit flexible. La couche conductrice est généralement collée sur le substrat au moyen d'une fine couche de matériau adhésif électriquement isolant (dont l'épaisseur est par exemple de l'ordre de 20 µm) préalablement enduite sur le substrat.

Un but de l'invention est de fournir une alternative aux procédés de fabrication des circuits flexibles de l'art antérieur, qui satisfasse aux exigences et spécifications requises pour ce type d'application tout en étant plus économique.

Dans le cas particulier des circuits imprimés flexibles pour les modules de carte à puce, un but de l'invention est de fournir un circuit flexible compatible avec les procédés et techniques usuels d'assemblage en continu des modules pour cartes à puce (fixage de puce - die-attach selon la terminologie anglo-saxonne, soudure de fils - « wire-bonding » selon la terminologie anglo-saxonne, encapsulation UV ou thermique) et avec les procédés usuels d'encartage des modules dans les corps de cartes.

A cet effet, il est prévu selon l'invention, un procédé de fabrication d'un circuit flexible dans lequel le substrat isolant habituellement en matériaux composites ou plastiques ou autre est supprimé.

De manière surprenante, les inventeurs ont pu montrer qu'un complexe constitué essentiellement d'au moins une feuille de matériau électriquement conducteur et d'une couche de matériau adhésif électriquement isolant peut suffire pour structurer et métalliser un circuit imprimé (ce circuit imprimé comprenant par exemple des plages de contacts électriques, des pistes conductrices ou des alternances de pistes conductrices et d'inter pistes conductrices d'antenne planaire telles qu'utilisées dans les modules de cartes à puces « à contact » ou « dual »).

Le matériau adhésif est par exemple un epoxy modifié par un thermoplastique (de type polyamide par exemple). Sa viscosité est adaptée pour qu'il puisse être étalé par enduction à température ambiante sur une couche électriquement conductrice ou un substrat amovible. Par exemple sa viscosité est de l'ordre de 77 à 88 mPa.s. Il a par exemple une température de transition vitreuse Tg de l'ordre de 51,5°C plus ou moins 5°C. Son extrait sec correspond à environ 20% (par exemple 20,6% plus ou moins 0,6%). Son module E' mesuré à 1Hz et à 20,539 °C est par exemple de 1,4x10⁹ Pa et il a une tanΔ maximale égale à 0,5945 à 56,307°C. Il peut également être chargé en métaux. On choisira de manière plus générale un matériau adhésif pouvant être appliqué par enduction à température ambiante (inférieure à 50°C). Il est adhésif par le fait qu'il adhère sur le support sur lequel il est enduit. Il peut également être adhésif par le fait que même après enduction et séchage, ses propriétés adhésives peuvent être réactivées par chauffage, sa température de transition vitreuse Tg étant préférentiellement inférieure à 100°C.

Le procédé de fabrication d'un circuit flexible selon l'invention comprend donc la fourniture d'une première feuille de matériau électriquement conducteur et le dépôt sur celle-ci d'une couche de matériau adhésif électriquement isolant. Une première face du matériau adhésif est mise en contact avec l'une des faces de la première feuille de matériau électriquement conducteur. Cependant, la deuxième face du matériau adhésif n'est pas au contact d'un substrat isolant contrairement aux procédés de l'art antérieur. Ainsi, le procédé selon l'invention passe par une étape au niveau de laquelle le circuit flexible ne comporte que la première feuille de matériau électriquement conducteur et la couche de matériau adhésif, sans substrat isolant ou diélectrique pour supporter ce complexe. La deuxième face du matériau adhésif est libre. Au moins une zone de la deuxième face du matériau adhésif peut donc être laissée découverte. Avantageusement, cette caractéristique est combinée avec l'utilisation d'un matériau adhésif formulé spécifiquement pour avoir des propriétés thermofusibles (hot-melt selon la terminologie anglo-saxonne) et réactivable aux températures usuelles d'encartage (par exemple à une température de l'ordre de 180°C). Ainsi, des modules pour cartes à puce découpés dans le circuit flexible peuvent être incorporés et collés dans la carte à puce directement sans étape supplémentaire de dépôt ou de lamination de film adhésif thermofusible au dos des modules. Il suffit pour les encarter, d'intégrer et de chauffer les modules obtenus par le procédé selon l'invention.

Le complexe ainsi obtenu peut être utilisé pour faire un circuit flexible simple face, c'est-à-dire avec un matériau électriquement conducteur sur une face pour former par exemple des plages de contacts électriques tandis que l'autre face (la deuxième face de la couche de matériau adhésif) est essentiellement constituée du matériau adhésif libre.

En ajoutant une deuxième feuille de matériau électriquement conducteur, sur la deuxième face de la couche de matériau adhésif, on peut utiliser le complexe obtenu par le procédé selon l'invention pour former un circuit flexible double face, c'est-à-dire avec un matériau électriquement conducteur sur chacune de ses faces (la couche de matériau adhésif étant entre les première et deuxième feuilles de matériau électriquement conducteur) pour former par exemple des plages de contacts électriques sur une face et des pistes conductrices et/ou des spires d'antenne planaire (par exemple une antenne ISO 14443-1 classe 1 - dite antenne ISO - ou classe 2 - dite ½ ISO) sur l'autre face.

Par convention, la face principale du circuit flexible pour modules de carte puce sur laquelle sont disposés les contacts est appelée face avant ou face contact (destinée à venir en regard d'un lecteur de carte à puce). Le circuit flexible a bien entendu une épaisseur délimitée par cette face avant et une autre face principale opposée à celle-ci et appelée face arrière ou face de la puce, par laquelle ou sur laquelle peut être collée une puce. Le circuit flexible pour modules de carte puce ne comporte pas nécessairement une puce lors de sa première commercialisation, mais en vue d'une connexion électrique ultérieure de la puce avec les plages de contacts de la face avant, il est prévu de réaliser au moins un puits de connexion au moins partiellement obturé par une zone arrière du contact. Les puits de connexion sont réalisés lors d'une étape de perforation mécanique de type poinçon-matrice ou bien par laser.

Selon la technologie de connexion par soudure de fils, la puce est montée dans l'épaisseur du substrat ou sur la face arrière du substrat. Elle est alors électriquement connectée aux contacts de la face avant par des fils conducteurs soudés dans les puits de connexion. De manière alternative, la puce munie de protubérances adaptées (« bumps » selon la terminologie anglo-saxonne) peut-être connectée aux contacts selon la technologie de la puce retournée (« flip-chip » selon la technologie anglo-saxonne), c'est-à-dire sur des plages métalliques situées sur la face arrière et reliées aux contacts de la face avant par des puits de connexion dont la paroi est métallisée (structure double-face à trous métallisés). L'un des avantages de la présente invention est de pouvoir connecter une puce munie de ces protubérances conductrices aux plages de contact de la face avant non seulement dans une structure double-face mais également dans une structure simple-face grâce à l'ajustement aisé de l'épaisseur de la couche de matériau adhésif avec la hauteur des protubérances conductrices de la puce (par exemple de l'ordre de 30 µm de haut). En effet, les techniques d'enduction telles que l'enduction par rouleau inversé (reverse roll coating selon la terminologie anglo-saxonne) ou l'encollage en rideau (curtain coating selon la terminologie anglo-saxonne) permettent de déposer des épaisseurs de matériaux adhésifs très fines (jusqu'à 5 µm après séchage par exemple) avec une tolérance resserrée pour s'ajuster à la hauteur des protubérances conductrices. Un tel module simple-face avec une puce ainsi connectée directement à travers des ouvertures réalisées dans la couche de matériau adhésif est économiquement très avantageux par rapport à un module simple face avec une puce connectée avec des fils d'or soudés de 25 µm de diamètre, ou un module double-face avec des trous métallisés pour connecter la puce.

La couche de matériau adhésif n'est pas nécessairement autoportante. Dans ce cas, il faut la déposer sur un support avec les technologies d'enduction mentionnées précédemment. La première feuille de matériau électriquement conducteur peut être alors utilisée comme support. Le complexe ainsi obtenu peut ensuite être perforé, puis recouvert de la deuxième feuille de matériau électriquement conducteur.

De manière alternative, la couche de matériau adhésif est déposée sur un substrat amovible (un substrat constitué d'une feuille de papier transfert par exemple). Le complexe intermédiaire ainsi obtenu peut être perforé, puis recouvert de la première feuille de matériau électriquement conducteur. Le substrat amovible peut ensuite être retiré. Par exemple, il peut être pelé, au moment de la lamination à chaud de la feuille de matériau électriquement conducteur.

Les première et deuxième feuilles de matériau électriquement conducteur sont par exemple constituées, chacune ou toutes deux, d'un métal tel que du cuivre ou un alliage de cuivre, de l'acier ou de l'aluminium.

Dans le cas des circuits flexibles pour carte à puce, les plages de contacts électriques et les pistes conductrices peuvent être réalisées sur les première et deuxième feuilles de matériau électriquement conducteur par gravure chimique ou par découpe mécanique selon la technologie dite de « leadframe », c'est-à-dire selon laquelle une grille de connexion est découpée avec une presse mécanique dans une feuille de matériau électriquement conducteur pour former plusieurs contacts électriques éventuellement reliés par des pistes conductrices. Après découpe mécanique, puis éventuellement métallisation de la grille de connexion, celle-ci est laminée sur la couche de matériau adhésif préalablement enduite sur une première feuille de matériau électriquement conducteur ou sur un substrat amovible.

L'invention concerne également un circuit flexible pour module de carte à puce obtenu par ce procédé, voire un module de carte à puce comprenant un tel circuit flexible.

D'autres caractéristiques et avantages de l'invention apparaîtront à la lecture de la description détaillée et des dessins annexés sur lesquels :
- La figure 1 représente schématiquement en perspective une carte à puce destinée à recevoir un circuit flexible selon l'invention ;
- Les figures 2a à 2m représentent schématiquement les différentes étapes d'un exemple de procédé conforme à l'invention ;
- les figures 3a à 3e représentent schématiquement les différentes étapes d'un autre exemple de procédé conforme à l'invention ; et
- la figure 4 représente schématiquement un exemple de circuit flexible obtenu avec le procédé selon l'invention.

Plusieurs modes de réalisation et variantes de circuits flexibles selon l'invention sont décrits ci-dessous. Tous appartiennent au domaine de la carte à puce, mais comme cela a déjà été mentionné, des applications dans d'autres domaines (antennes RFID, LEDs, etc.) sont aisément transposables.

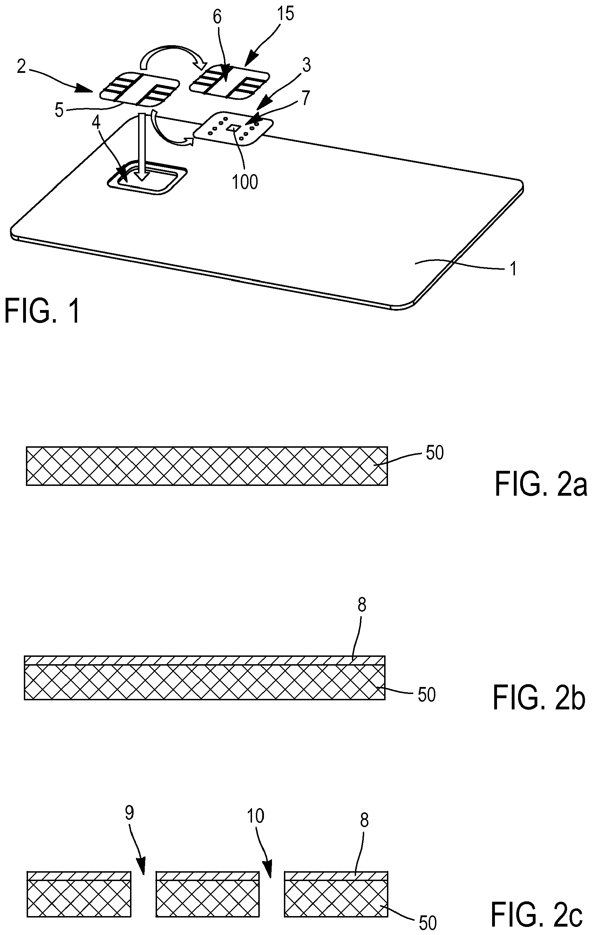

Comme représenté sur la figure 1, une carte à puce 1 comporte un module 2. Le module 2 comprend un circuit flexible 3 et une puce 100. Le module 2 est généralement réalisé sous forme d'un élément séparé qui est inséré dans une cavité 4 ménagée dans la carte 1.

Le circuit flexible 3 comporte plusieurs contacts 15 auxquels est connectée la puce 100. Le circuit flexible 3 est représenté (en haut) vu par sa face avant 6 (face contact). Il est aussi représenté (en bas) vu par sa face arrière 7. Le circuit flexible 3 représenté correspond à un circuit flexible simple face pour carte « à contact ». Mais il pourrait tout aussi bien s'agir d'un circuit flexible double face pour carte « dual ».

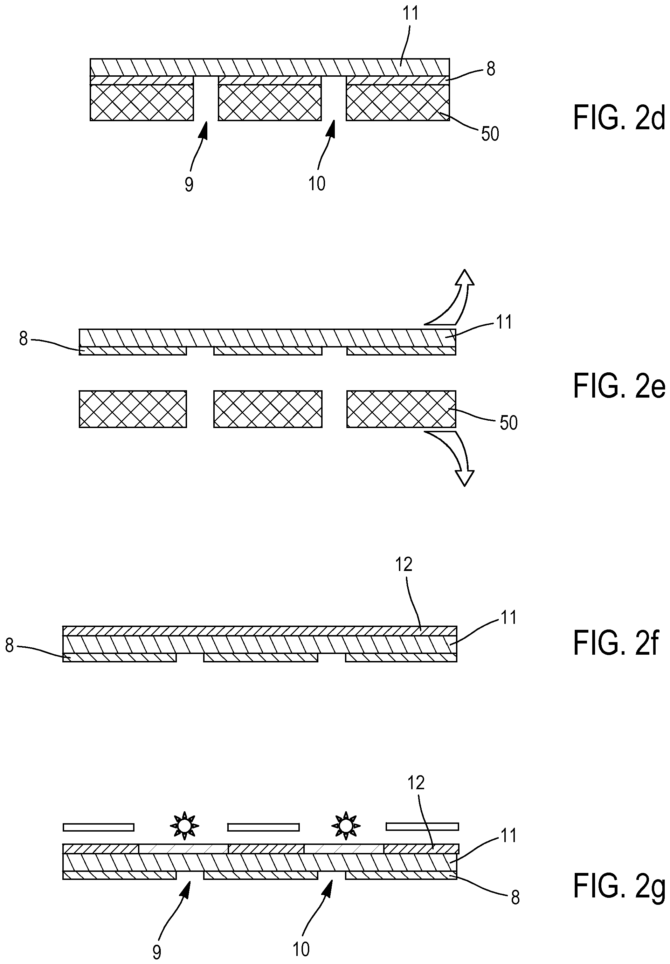

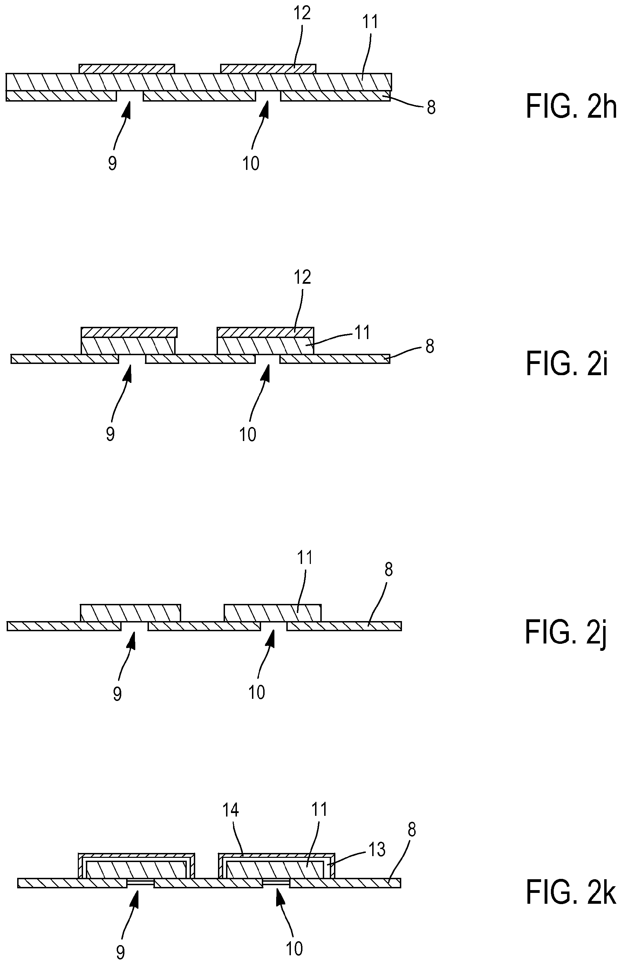

Les figures 2a à 2m illustrent schématiquement différentes étapes d'un exemple de procédé selon l'invention pour la fabrication du circuit flexible 3. Les étapes de ce procédé comprennent :
- la fourniture (Fig. 2a) d'un substrat amovible 50 de type papier transfert ayant par exemple une épaisseur de l'ordre de 80 g/m²;
- l'enduction (Fig. 2b) du substrat amovible 50 avec une couche d'adhésif 8 ayant par exemple une épaisseur de l'ordre de 50 µm après séchage;
- la perforation (Fig. 2c) de l'ensemble du substrat amovible 50 et de la couche d'adhésif, afin de réaliser des puits de connexion 9 et éventuellement une cavité 10 dans laquelle sera logée ultérieurement une puce ;
- la lamination à chaud d'une première feuille de matériau conducteur 11 ayant par exemple une épaisseur de l'ordre de 18 µm ou de 35 µm sur la couche d'adhésif 8 (Fig. 2d) et le pelage simultané du substrat amovible 50 (Fig. 2e) car la couche d'adhésif se transfère entièrement sur la feuille de matériau conducteur lors de cette étape de lamination à chaud du matériau conducteur ;
- la polymérisation à chaud (thermique) ou à basse température (UV) de la couche d'adhésif 8 ;
- la lamination d'un film sec de résine photosensible (photoresist selon la terminologie anglo-saxonne) 12 sur la face libre de la première feuille de matériau électriquement conducteur (Fig. 2f),
- l'insolation du film de résine photosensible 12 (Fig. 2g),
- le développement chimique du film de résine photosensible 12 non insolé (Fig. 2h),
- la gravure chimique de la couche conductrice 11 dans les zones non protégées par le film de résine photosensible 12 (Fig. 2i),
- la dissolution (« strippage » selon la terminologie anglo-saxonne) du film de résine photosensible 12 insolé (Fig. 2j), et
- la métallisation par galvano-chimie des pistes et contacts obtenus après gravure de la couche conductrice 11 en une ou plusieurs étapes pour former une couche de nickel 13 et une couche d'or ou de palladium 14 ou d'argent (Fig. 2k).

Certaines étapes du procédé décrit ci-dessus sont spécifiques à la réalisation de modules pour cartes à puce, mais les étapes de transfert d'une couche d'adhésif d'un substrat temporaire amovible sur une couche conductrice peuvent bien entendu être utilisées pour d'autres applications.

Le circuit flexible 3 ainsi réalisé peut être utilisé pour connecter une puce et réaliser un module électronique selon différentes technologies d'assemblage microélectronique.

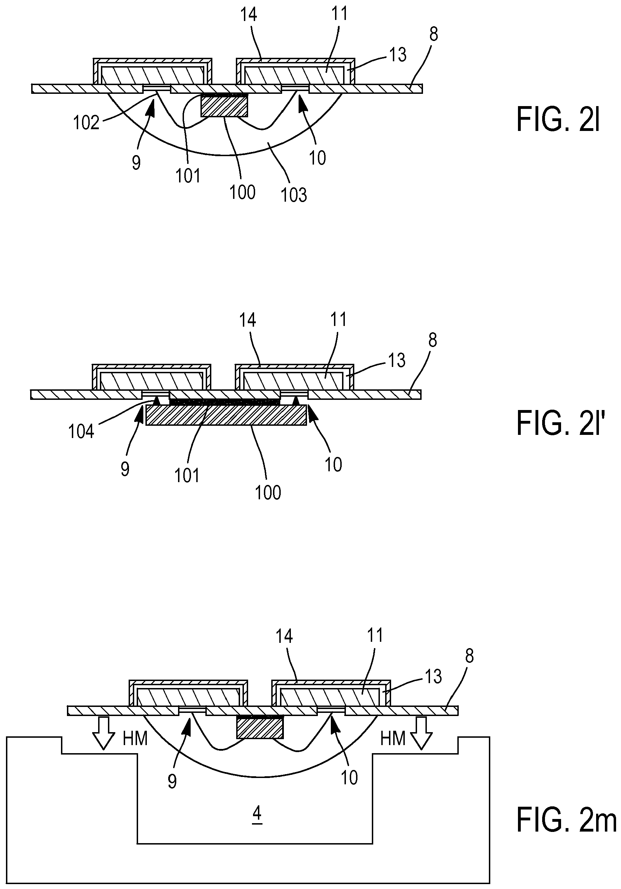

Ainsi, la figure 2l représente schématiquement le résultat d'étapes au cours desquelles une puce 100 est collée, avec une couche de colle 101, sur la face arrière 7 et reliée à la face avant 6 du circuit flexible par des fils 102 de connections en or de diamètre 25 µm protégés ensuite par une résine d'encapsulation 103.

Alternativement, comme représenté sur la figure 2l', la technologie « flip-chip » permet de coller, avec une couche de colle 101, une puce 100 reliée à la face avant 6 du circuit flexible par des protubérances conductrices 104 (« bumps » selon la technologie anglo-saxonne) situées sous la puce en face arrière 7. Le module 2 comporte donc une puce 100 connectée électriquement directement aux contacts 15 grâce à des protubérances conductrices 104 logées dans les puits de connexions 9.

Avantageusement, l'utilisation d'un matériau adhésif 8 spécialement formulé pour avoir des propriétés thermofusibles (« hot-melt » selon la terminologie anglo-saxonne) intrinsèques et irréversibles permet d'encarter directement le module 2 obtenu dans la cavité 4 aménagée dans le corps de la carte 1 sans adjonction de film thermofusible supplémentaire (Fig. 2m) comme c'est le cas dans l'art antérieur. Il suffit pour cela de faire subir à l'ensemble constitué du module 2 pressé sur le corps de carte 1, un traitement thermique approprié qui permet aux zones (au niveau des flèches HM) où l'adhésif 8 est à nu de coller aux bords de la cavité 4. Sur la figure 2m est représenté le module de la figure 2l, mais le module représenté sur la figure 2l' peut être utilisé de manière équivalente.

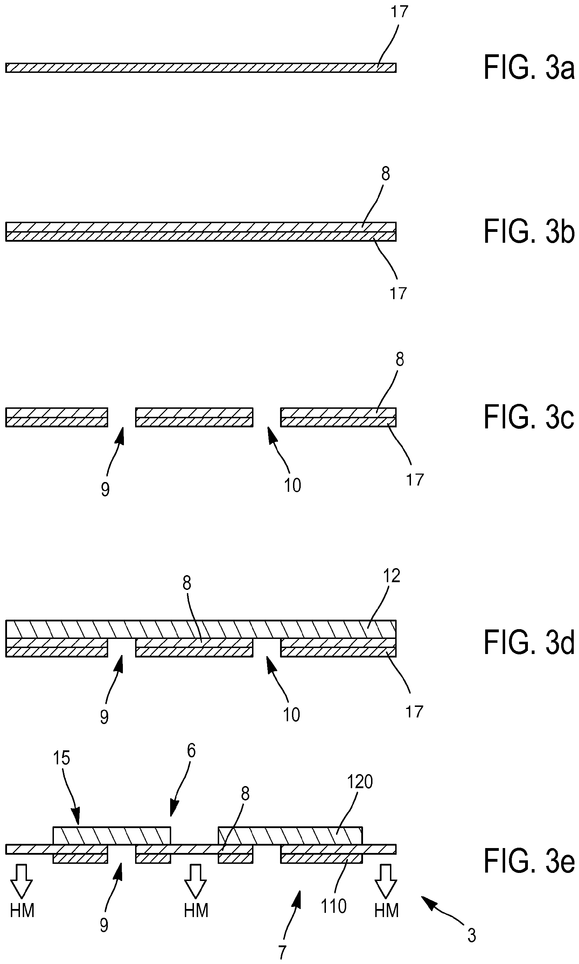

Un autre procédé de fabrication du circuit flexible selon l'invention aboutissant à une structure double-face est représenté sur les figures 3a à 3e. Les étapes de ce procédé comprennent :
- la fourniture (Fig. 3a) d'une première feuille de matériau conducteur 17 ayant par exemple une épaisseur de l'ordre de 18 µm ou de 35 µm;
- l'enduction (Fig. 3b) de la première feuille de matériau conducteur 17 avec une couche d'adhésif 8 possédant éventuellement des propriétés thermofusibles;
- la perforation (Fig. 3c) de l'ensemble de la première feuille de matériau conducteur 17 et de la couche d'adhésif 8, afin de réaliser des puits de connexion 9 et éventuellement une cavité 10 dans laquelle sera logée ultérieurement une puce;
- la lamination d'une deuxième feuille de matériau conducteur 12 ayant par exemple une épaisseur de l'ordre de 18 µm ou de 35 µm sur la couche d'adhésif 8 (Fig. 3d);
- la polymérisation à chaud (thermique) ou à basse température (UV) de la couche d'adhésif 8;
- des étapes de masquage par film de résine photosensible, gravure chimique et métallisation similaires à celles décrites ci-dessus pour réaliser des plages de contacts électriques et des pistes conductrices sur l'une et l'autre des première et deuxième couches électriquement conductrices 17, 12.

Un exemple de circuit flexible 3 obtenu par cet autre procédé de fabrication est représenté sur la figure 3e. La structure obtenue est une structure double-face à trous non métallisés pour cartes « dual » par exemple.

Ce circuit flexible comporte une face avant 6 avec des contacts 15 métallisés (ici les couches de métaux précieux ne sont pas individuellement représentées, elles sont confondues dans des première 110 et deuxième 120 couches conductrices constituées respectivement d'une première et deuxième couches de matériau conducteur, tel qu'un alliage de cuivre, recouvertes de nickel et d'or ou de palladium. Il comporte également une face arrière 7 avec des trous de connexion 9 et une cavité pour recevoir une puce ultérieurement. Des zones de la couche de matériau adhésif restent découvertes de manière à être utilisées, par exemple au niveau des flèches HM, pour un collage ultérieur du module 2 dans sa cavité 4 (par la technique « hot-melt » par exemple).

De manière similaire, il est possible d'obtenir une structure double-face à trous métallisés utilisée dans les modules de certaines cartes à « contact » ou bien dans les modules avec antenne pour certaines cartes « Dual ».

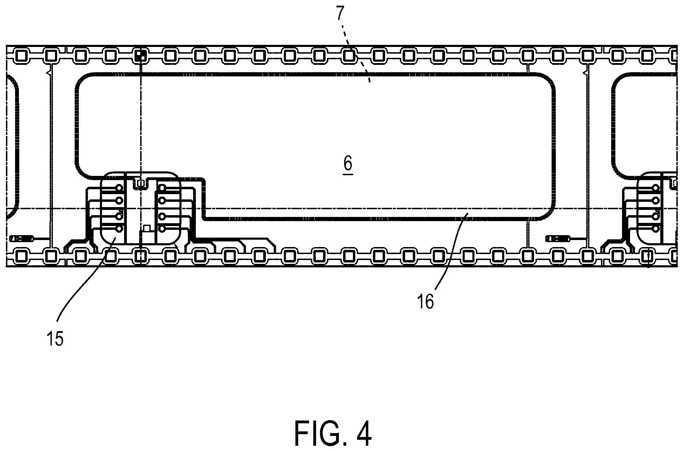

Un exemple de circuit flexible pour réaliser une carte « dual » est schématiquement représenté sur la figure 4. Il comporte des contacts 15 métallisés sur la face avant 6 et une antenne planaire 16 sur la face arrière 7. Les pistes conductrices et l'antenne 16 réalisées sur la face arrière 7 sont représentées en traits pointillés tandis que les contacts 15 de la face avant 6 sont représentés en traits pleins. Entre les contacts 15 d'une part et les pistes conductrices et l'antenne 16 d'autre part est intercalée une couche de matériau adhésif 8. Dans cet exemple, l'antenne est au format ISO 14443-1 classe 2 pour être compatible avec une carte présentant des lignes d'embossage (zone interdite pour les spires de l'antenne), mais un circuit flexible pour carte « dual » avec une antenne deux fois plus grande (c'est-à-dire au format ISO 14443-1 classe 1) est réalisable de la même façon si la carte ne présente pas de lignes d'embossage. De même, cet exemple correspond à une structure sur laquelle une puce peut être collée en face arrière et connectée à l'aide de fils conducteurs aux contacts 15 à travers les trous de connexion 9. La transposition à une structure à trous métallisés est évidemment tout à fait possible.

L'un des avantages des procédés décrits ci-dessus réside dans le fait qu'ils peuvent être mis en oeuvre de façon continue en utilisant des bobines sur lesquelles sont enroulées des bandes de matériau conducteur plus longues et donc avec moins de raccords matière entre les bandes, qu'avec les bandes de substrats en matériaux composites ou plastiques. Ceci réduit, par rapport aux procédés de l'art antérieur, le nombre d'interventions pour changer les bobines et la quantité de chutes générées à chaque raccord matière avec pour conséquence immédiate une amélioration des rendements de production.

## Revendications

1. Procédé de fabrication d'un circuit imprimé flexible (3) comprenant une face avant (6) et une face arrière (7), ce procédé comprenant :
- la fourniture d'une feuille de matériau électriquement conducteur (11 ou 12),
- le dépôt d'une couche de matériau adhésif (8) électriquement isolant, une première face du matériau adhésif étant en contact avec l'une des faces de la feuille de matériau électriquement conducteur (11 ou 12),
**caractérisé par le fait**
- **qu'**on laisse découverte au moins une zone de la deuxième face du matériau adhésif (8),
- **qu'**une puce (100) est reportée en face arrière (7), sur la deuxième face de la couche de matériau adhésif (8) ou dans une cavité ménagée dans la couche de matériau adhésif (8),
- **que** la feuille de matériau électriquement conducteur (11 ou 12) est structurée et métallisée pour former, en face avant (6), des contacts (15) pour module de carte à puce,
- et par le fait que la couche de matériau adhésif (8) est perforée avant que la feuille de matériau électriquement conducteur (11 ou 12) ne soit appliquée sur la première face du matériau adhésif (8).

2. Procédé selon la revendication 1, comportant une étape au niveau de laquelle le circuit flexible (3) ne comporte qu'une feuille de matériau électriquement conducteur (11 ou 12) et la couche de matériau adhésif (8).

3. Procédé selon la revendication 1 ou 2, comportant en outre l'application d'une autre feuille de matériau électriquement conducteur (17), sur la deuxième face de la couche de matériau adhésif (8).

4. Procédé selon l'une des revendications précédentes, dans lequel le dépôt de la couche de matériau adhésif (8) est réalisé par enduction.

5. Procédé selon l'une des revendications 1 à 3, dans lequel un complexe intermédiaire est réalisé en déposant la couche de matériau adhésif (8) préalablement sur un substrat amovible (50).

6. Procédé selon la revendication 5, dans lequel le complexe intermédiaire constitué de la couche de matériau adhésif (8) et du substrat amovible (50) est perforé.

7. Procédé selon la revendication 5 ou 6, dans lequel la feuille de matériau électriquement conducteur (11) est déposée sur le complexe intermédiaire constitué de la couche de matériau adhésif (8) et du substrat amovible (50).

8. Procédé selon l'une des revendications précédentes, dans lequel le matériau adhésif (8) est un epoxy modifié par un thermoplastique.

9. Procédé selon l'une des revendications précédentes, dans lequel le matériau adhésif (8) possède des propriétés thermofusibles intrinsèques.

10. Procédé selon l'une des revendications précédentes, dans lequel la feuille de matériau électriquement conducteur (11 ou 12) est gravée pour réaliser des plages de contacts électriques (15).

11. Circuit imprimé flexible comprenant une face avant (6) et une face arrière (7), ce circuit imprimé comportant
- une feuille de matériau électriquement conducteur (11) dans laquelle est réalisé, en face avant (6), au moins un contact (15) électriquement conducteur,
- une couche de matériau adhésif (8) électriquement isolant, ayant la première de ses deux faces en contact avec l'une des faces du matériau électriquement conducteur (11),
**caractérisé par le fait**
- **que** la deuxième des deux faces face du matériau adhésif comporte au moins une zone sur laquelle la couche de matériau adhésif (8) est découverte,
- **qu'**il comporte une puce (100) reportée en face arrière (7), sur la deuxième face de la couche de matériau adhésif (8) ou dans une cavité ménagée dans la couche de matériau adhésif (8),
- et par le fait que la couche de matériau adhésif (8) est perforée pour former des trous de connexion (9).

12. Circuit imprimé flexible selon la revendication 11, comportant une autre feuille de matériau électriquement conducteur (17) sur la deuxième face de la couche de matériau adhésif (8).

13. Circuit imprimé flexible selon la revendication 12, comportant au moins une spire d'antenne planaire sur l'autre feuille de matériau électriquement conducteur (17).

14. Circuit imprimé flexible selon l'une des revendications 11 à 13, dans lequel le matériau adhésif (8) est un epoxy modifié par un thermoplastique.

15. Module de carte à puce, comportant un circuit imprimé flexible (3) comprenant une face avant (6) et une face arrière (7), ce circuit imprimé comportant
- au moins un contact (15) électriquement conducteur réalisé, en face avant (6), dans une feuille de matériau électriquement conducteur (11 ou 12),
- une couche de matériau adhésif (8) électriquement isolant, ayant une première de ses deux faces en contact avec l'une des faces de la feuille de matériau électriquement conducteur (11 ou 12),
**caractérisé par le fait**
- **que** la deuxième des deux faces du matériau adhésif (8) comporte au moins une zone sur laquelle la couche de matériau adhésif (8) est découverte,
- **qu'**il comporte une puce (100) reportée en face arrière (7), sur la deuxième face de la couche de matériau adhésif (8) ou dans une cavité ménagée dans la couche de matériau adhésif (8),
- et par le fait que la couche de matériau adhésif (8) est perforée pour former des trous de connexion (9), à travers lesquels la puce (100) est connectée électriquement au contact (15).

16. Module selon la revendication 15, comportant une autre feuille de matériau électriquement conducteur (17) sur la deuxième face de la couche de matériau adhésif (8).

17. Module selon la revendication 15 ou 16, dans lequel le matériau adhésif (8) est un epoxy modifié par un thermoplastique.

18. Module selon l'une des revendications 15 à 17, dans lequel la puce (100) est connectée grâce à une protubérance conductrice (104).

19. Module selon l'une des revendications 15 à 18, dans lequel la puce est connectée électriquement à la fois à au moins un contact électrique (15) et une antenne (16).

## Patentansprüche

1. Verfahren zur Herstellung einer flexiblen Leiterplatte (3), die eine Vorderseite (6) und eine Rückseite (7) umfasst, wobei dieses Verfahren umfasst:
- die Bereitstellung einer Folie aus elektrisch leitendem Material (11 oder 12),
- die Aufbringung einer Schicht aus elektrisch isolierendem Haftmaterial (8), wobei sich eine erste Seite des Haftmaterials in Kontakt mit einer der Seiten der Folie aus elektrisch leitendem Material (11 oder 12) befindet,
**dadurch gekennzeichnet,**
- **dass** wenigstens ein Bereich der zweiten Seite des Haftmaterials (8) unbedeckt gelassen wird,
- **dass** ein Chip (100) an der Rückseite (7) angebracht wird, auf der zweiten Seite der Schicht aus Haftmaterial (8) oder in einem Hohlraum, der in der Schicht aus Haftmaterial (8) ausgebildet ist,
- **dass** die Folie aus elektrisch leitendem Material (11 oder 12) strukturiert und metallisiert wird, um auf der Vorderseite (6) Kontakte (15) für ein Chipkartenmodul auszubilden,
und dadurch, dass die Schicht aus Haftmaterial (8) perforiert wird, bevor die Folie aus elektrisch leitendem Material (11 oder 12) auf der ersten Seite des Haftmaterials (8) angebracht wird.

2. Verfahren nach Anspruch 1, welches einen Schritt umfasst, in dem die flexible Leiterplatte (3) nur eine Folie aus elektrisch leitendem Material (11 oder 12) und die Schicht aus Haftmaterial (8) aufweist.

3. Verfahren nach Anspruch 1 oder 2, welches außerdem die Anbringung einer weiteren Folie aus elektrisch leitendem Material (17) auf der zweiten Seite der Schicht aus Haftmaterial (8) umfasst.

4. Verfahren nach einem der vorhergehenden Ansprüche, wobei die Aufbringung der Schicht aus Haftmaterial (8) durch Beschichten realisiert wird.

5. Verfahren nach einem der Ansprüche 1 bis 3, wobei eine komplexe Zwischenschicht hergestellt wird, indem die Schicht aus Haftmaterial (8) zuvor auf ein entfernbares Substrat (50) aufgebracht wird.

6. Verfahren nach Anspruch 5, wobei die komplexe Zwischenschicht, die aus der Schicht aus Haftmaterial (8) und dem entfernbaren Substrat (50) besteht, perforiert wird.

7. Verfahren nach Anspruch 5 oder 6, wobei die Folie aus elektrisch leitendem Material (11) auf die komplexe Zwischenschicht aufgebracht wird, die aus der Schicht aus Haftmaterial (8) und dem entfernbaren Substrat (50) besteht.

8. Verfahren nach einem der vorhergehenden Ansprüche, wobei das Haftmaterial (8) ein mit einem Thermoplast modifiziertes Epoxidharz ist.

9. Verfahren nach einem der vorhergehenden Ansprüche, wobei das Haftmaterial (8) intrinsische Wärmeschmelzbarkeitseigenschaften besitzt.

10. Verfahren nach einem der vorhergehenden Ansprüche, wobei die Folie aus elektrisch leitendem Material (11 oder 12) geätzt wird, um Bereiche elektrischer Kontakte (15) herzustellen.

11. Flexible Leiterplatte, welche eine Vorderseite (6) und eine Rückseite (7) umfasst, wobei diese flexible Leiterplatte aufweist:
- eine Folie aus elektrisch leitendem Material (11), in welcher auf der Vorderseite (6) wenigstens ein elektrisch leitender Kontakt (15) ausgebildet ist,
- eine Schicht aus elektrisch isolierendem Haftmaterial (8), bei der sich die erste ihrer zwei Seiten in Kontakt mit einer der Seiten des elektrisch leitenden Materials (11) befindet,
**dadurch gekennzeichnet,**
- **dass** die zweite der zwei Seiten des Haftmaterials wenigstens einen Bereich aufweist, auf welchem die Schicht des Haftmaterials (8) unbedeckt ist,
- **dass** sie einen Chip (100) aufweist, der an der Rückseite (7) angebracht ist, auf der zweiten Seite der Schicht aus Haftmaterial (8) oder in einem Hohlraum, der in der Schicht aus Haftmaterial (8) ausgebildet ist,
- und dadurch, dass die Schicht aus Haftmaterial (8) perforiert ist, um Verbindungslöcher (9) auszubilden.

12. Flexible Leiterplatte nach Anspruch 11, welche eine weitere Folie aus elektrisch leitendem Material (17) auf der zweiten Seite der Schicht aus Haftmaterial (8) aufweist.

13. Flexible Leiterplatte nach Anspruch 12, welche wenigstens eine Windung einer planaren Antenne auf der weiteren Folie aus elektrisch leitendem Material (17) aufweist.

14. Flexible Leiterplatte nach einem der Ansprüche 11 bis 13, wobei das Haftmaterial (8) ein mit einem Thermoplast modifiziertes Epoxidharz ist.

15. Chipkartenmodul, welches eine flexible Leiterplatte (3) aufweist, die eine Vorderseite (6) und eine Rückseite (7) umfasst, wobei diese Leiterplatte aufweist:
- wenigstens einen elektrisch leitenden Kontakt (15), der auf der Vorderseite (6) in einer Folie aus elektrisch leitendem Material (11 oder 12) ausgebildet ist,
- eine Schicht aus elektrisch isolierendem Haftmaterial (8), bei der sich eine erste ihrer zwei Seiten in Kontakt mit einer der Seiten Folie aus elektrisch leitendem Material (11 oder 12) befindet,
**dadurch gekennzeichnet,**
- **dass** die zweite der zwei Seiten des Haftmaterials (8) wenigstens einen Bereich aufweist, auf welchem die Schicht des Haftmaterials (8) unbedeckt ist,
- **dass** es einen Chip (100) aufweist, der an der Rückseite (7) angebracht ist, auf der zweiten Seite der Schicht aus Haftmaterial (8) oder in einem Hohlraum, der in der Schicht aus Haftmaterial (8) ausgebildet ist,
- und dadurch, dass die Schicht aus Haftmaterial (8) perforiert ist, um Verbindungslöcher (9) auszubilden, durch welche hindurch der Chip (100) mit dem Kontakt (15) elektrisch verbunden ist.

16. Modul nach Anspruch 15, welches eine weitere Folie aus elektrisch leitendem Material (17) auf der zweiten Seite der Schicht aus Haftmaterial (8) aufweist.

17. Modul nach Anspruch 15 oder 16, wobei das Haftmaterial (8) ein mit einem Thermoplast modifiziertes Epoxidharz ist.

18. Modul nach einem der Ansprüche 15 bis 17, wobei der Chip (100) mithilfe eines leitfähigen Vorsprungs (104) verbunden ist.

19. Modul nach einem der Ansprüche 15 bis 18, wobei der Chip gleichzeitig mit wenigstens einem elektrischen Kontakt (15) und einer Antenne (16) elektrisch verbunden ist.

## Claims

1. Method for manufacturing a flexible printed circuit (3) comprising a front face (6) and a rear face (7), this method comprising:
- providing a sheet of electrically conductive material (11 or 12),
- depositing a layer of electrically insulating adhesive material (8), a first face of the adhesive material being in contact with one of the faces of the sheet of electrically conductive material (11 or 12),
**characterized**
- **in that** at least one area of the second face of the adhesive material (8) is left exposed,
- **in that** a chip (100) is added to the rear face (7), on the second face of the layer of adhesive material (8) or in a cavity formed in the layer of adhesive material (8),
- **in that** the sheet of electrically conductive material (11 or 12) is structured and metallized so as to form, on the front face (6), contacts (15) for a chip card module,
- and **in that** the layer of adhesive material (8) is perforated before the sheet of electrically conductive material (11 or 12) is applied to the first face of the adhesive material (8).

2. Method according to Claim 1, including a step in which the flexible circuit (3) includes only a sheet of electrically conductive material (11 or 12) and the layer of adhesive material (8).

3. Method according to Claim 1 or 2, furthermore including the application of another sheet of electrically conductive material (17) on the second face of the layer of adhesive material (8).

4. Method according to one of the preceding claims, wherein the layer of adhesive material (8) is deposited by coating.

5. Method according to one of Claims 1 to 3, wherein an intermediate complex is formed by depositing the layer of adhesive material (8) beforehand on a removable substrate (50).

6. Method according to Claim 5, wherein the intermediate complex consisting of the layer of adhesive material (8) and of the removable substrate (50) is punched.

7. Method according to Claim 5 or 6, wherein the sheet of electrically conductive material (11) is deposited on the intermediate complex consisting of the layer of adhesive material (8) and of the removable substrate (50).

8. Method according to one of the preceding claims, wherein the adhesive material (8) is a thermoplastic-modified epoxy.

9. Method according to one of the preceding claims, wherein the adhesive material (8) has inherent hot-melt properties.

10. Method according to one of the preceding claims, wherein the sheet of electrically conductive material (11 or 12) is etched so as to form electrical contact pads (15).

11. Flexible printed circuit comprising a front face (6) and a rear face (7), this printed circuit including:
- a sheet of electrically conductive material (11) in which there is formed, on the front face (6), at least one electrically conductive contact (15),
- a layer of electrically insulating adhesive material (8), having the first of its two faces in contact with one of the faces of the electrically conductive material (11),
**characterized**
- **in that** the second of the two faces of the adhesive material includes at least one area on which the layer of adhesive material (8) is exposed,
- **in that** it includes a chip (100) added to the rear face (7), on the second face of the layer of adhesive material (8) or in a cavity formed in the layer of adhesive material (8),
- and **in that** the layer of adhesive material (8) is punched so as to form connecting holes (9).

12. Flexible printed circuit according to Claim 11, including another sheet of electrically conductive material (17) on the second face of the layer of adhesive material (8).

13. Flexible printed circuit according to Claim 12, including at least one flat antenna turn on the other sheet of electrically conductive material (17).

14. Flexible printed circuit according to one of Claims 11 to 13, wherein the adhesive material (8) is a thermoplastic-modified epoxy.

15. Chip card module, including a flexible printed circuit (3) comprising a front face (6) and a rear face (7), this printed circuit including
- at least one electrically conductive contact (15) formed, on the front face (6), from a sheet of electrically conductive material (11 or 12),
- a layer of electrically insulating adhesive material (8), having a first of its two faces in contact with one of the faces of the sheet of electrically conductive material (11 or 12),
**characterized**
- **in that** the second of the two faces of the adhesive material (8) includes at least one area on which the layer of adhesive material (8) is exposed,
- **in that** it includes a chip (100) added to the rear face (7), on the second face of the layer of adhesive material (8) or in a cavity formed in the layer of adhesive material (8),
- and **in that** the layer of adhesive material (8) is punched so as to form connecting holes (9) through which the chip (100) is electrically connected to the contact (15).

16. Module according to Claim 15, including another sheet of electrically conductive material (17) on the second face of the layer of adhesive material (8).

17. Module according to Claim 15 or 16, wherein the adhesive material (8) is a thermoplastic-modified epoxy.

18. Module according to one of Claims 15 to 17, wherein the chip (100) is connected by virtue of a conductive protrusion (104).

19. Module according to one of Claims 15 to 18, wherein the chip is electrically connected to both at least one electrical contact (15) and an antenna (16).
